# EUROPEAN PATENT APPLICATION

(11) **EP 3 328 169 A1**
(43) Date of publication of application: **30.05.2018**
(21) Application number: 16382557.3
(22) Date of filing: 24.11.2016
(51) Int. Cl.: H05K 3/14, H05K 3/22, H05K 3/24

(54) **METHOD FOR PROVIDING ELECTRICAL CONTINUITY IN A CIRCUIT AND ELECTRONICAL ASSEMBLY**

(71) Applicant: VALEO ILUMINACION, 23600 Martos (ES)
(72) Inventor: TEBA, Daniel, 23600 Martos (Jaen) (ES); GUZMAN, Alfonso-Manuel, 23560 Huelma (Jaen) (ES); MARTINEZ, Francisco, 18500 Guadix (Granada) (ES)

(57) **Abstract**

The invention provides a method for providing electrical continuity in an electronic assembly (1), the method comprising the steps of providing a three-dimensional plastics substrate (2), directly depositing a conductive track (3) on the three-dimensional plastics substrate (2) and providing a conductive material (5). The conductive track (3) has a discontinuity (4) that keeps electric current from passing from a first end (41) of the discontinuity (4) to a second end (42) of the discontinuity (4). The conductive material (5) is provided in electric contact with both the first end (41) and the second end (42) of the discontinuity (4).

## Description

### TECHNICAL FIELD

The present invention belongs to the field of electronic assemblies comprising conductive tracks directly deposited on a plastics substrate.

### STATE OF THE ART

Directly depositing a conductive track on a plastics substrate normally supposes substantial cost savings, mainly due to the fact that a dedicated printed circuit board need not be provided. Therefore, other integral parts of the device to be controlled with the electronic assembly can be taken advantage of to play the role of substrate for the conductive track.

Furthermore, the process of direct deposition of the conductive track usually implies shorter manufacturing times and conductive material savings - in contrast to most PCB manufacturing methods, there is no need for removing regions of conductive material or for using an additional product, such as an electrolyte, to define the conductive track.

However, it has been discovered that conductive tracks which have been deposited by this method are very sensitive to roughness or irregularities which are present in said plastics substrates, and which may cause electric discontinuities in the tracks.

### DESCRIPTION OF THE INVENTION

The invention provides a solution for this problem by means of a method for providing electrical continuity in an electronic assembly according to claim 1, an electronic assembly according to claim 6 and a lighting device according to claim 10. Preferred embodiments of the invention are defined in dependent claims.

In an inventive aspect, the invention provides a method for providing electrical continuity in an electronic assembly, the method comprising the steps of
providing a plastics substrate;
directly depositing a conductive track on the plastics substrate, the conductive track having a discontinuity that keeps electric current from passing from a first end of the discontinuity to a second end of the discontinuity; and
providing a conductive material in electric contact with both the first end and the second end of the discontinuity thus achieving electrical continuity in the discontinuity, thereby obtaining an electronic assembly with electrical continuity.

Direct deposition of a conductive track on a plastics substrate should be construed as forming the final shape of the conductive track on the plastics substrate without the need of removing metal or for any other intermediate element, such as a mask, an electrolyte or any other chemical bath or a photosensitive film. The conductive track is just directly placed on the plastics substrate.

This method is suitable for recovering the functionality of an electric circuit which has been created by plasma deposition, and the electric conductivity thereof has been interrupted by an irregularity present in the plastics substrate.

In some particular embodiments, the step of directly depositing a conductive track on the plastics substrate is carried out by addressing a plasma flow which contains metal dust over the plastics substrate.

These particular embodiments use a simple technique to create the conductive track. The result is a very thin layer directly laid on the plastics substrate.

In some particular embodiments, the conductor material is placed in form of welding paste.

These embodiments allow that the amendment may be performed in a simple and non-expensive way.

In some particular embodiments, the conductive material is placed by addressing a plasma flow which contains dust particles of the conductive material over the plastics substrate.

These particular embodiments advantageously allow that the same machine that is used for creating the conductive track is also used to amend it in the event that some irregularity of the plastics substrate causes an interruption in the electric conductivity of the conductive track, whatever they come from, for instance, slider lines, inserts borders, mechanization roughness from the mould or any kind of flatness disruption of plastic part surface once is already injected.

In some particular embodiments, the plastics substrate is three-dimensional.

A three-dimensional plastics substrate should be construed as a plastics substrate whose surface on which the conductive track extends is not completely contained in a plane. Direct deposition is particularly appropriate for such three-dimensional surfaces, in comparison to other known techniques which normally require planar surfaces for printing a circuit board.

This device is suitable for being used in several applications, where a three-dimensional plastics substrate is required to provide lighting in a more complex environment.

In another inventive aspect, the invention provides an electronic assembly which has been obtained by a method according to the preceding inventive aspect.

This electronic assembly has electric continuity despite the presence of an irregularity which crosses a conductive track which has been directly deposited on it.

In another inventive aspect, the invention provides an electronic assembly comprising
a plastics substrate;
a conductive track directly deposited on the plastics substrate, the conductive track having a discontinuity that keeps electric current from passing from a first end of the discontinuity to a second end of the discontinuity; and
a conductive material in electric contact with both the first end and the second end of the discontinuity.

Advantageously, this electronic assembly works despite comprising an irregularity which, if no conductor material was present in the circuit, would cause a failure in its electric conductivity.

In a particular embodiment, the plastics substrate comprises an irregularity defining an irregularity border, in such a way that the first end of the discontinuity and the second end of the discontinuity are contained in the irregularity border, as explained above.

This is an example of a feature that may cause the loss of electrical continuity. This feature may be present in many plastic parts where the conductive tracks are deposited, which makes the electronic assembly of the invention suitable for this kind of parts.

In some particular embodiments, the irregularity is a slider line. These slider lines are very common in the manufacturing of lighting devices, and this fact makes the invention suitable for being applied to a high number of said devices.

In some particular embodiments, the plastics substrate is three-dimensional.

This device is suitable for being used in several applications, where a three-dimensional plastics substrate is required to provide lighting in a more complex environment.

In another inventive aspect, the invention provides a lighting device for automotive vehicle comprising
an electronic assembly according to the previous inventive aspect
a semiconductor light source in electric connection with the electronic assembly;
an optical element suitable for receiving light emitted by the light source and for shaping the light into a light pattern projected outside the lighting device; and
a housing accommodating the electronic assembly, the semiconductor light source and the optical element.

An optical element is an element that has some optical properties to receive a light beam and emit it in a certain direction and/or shape, as a person skilled in automotive lighting would construe without any additional burden. Reflectors, collimators, light guides, projection lenses, etc., or the combination thereof are some examples of these optical elements.

Lighting devices for automotive vehicles can benefit from the use of electronic assemblies comprising conductive tracks directly deposited on a plastics substrate. In the first place, a wide range of the lighting device's parts can be used either as plastics substrate or as base for the plastics substrate (in which case the plastics substrate may for instance coat the base), taking into account that even three-dimensional plastics substrates are suitable for direct deposition of conductive tracks. Therefore, a dedicated printed board circuit is not required, which leads to reducing the cost and the weight of the lighting device. As was stated above, cost savings are even more significant due to the fact that direct deposition does not normally want removing conductive material to shape the conductive tracks.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figures 1a and 1b show an electronic assembly before being subject of a method according to the invention.
Figure 2a and 2b show two alternatives of a step of a method according to the invention.
Figure 3 shows another electronic assembly according to the invention, after being subject of the method according to the invention.
Figure 4 shows a lighting device comprising an electronic assembly.

### DETAILED DESCRIPTION OF THE INVENTION

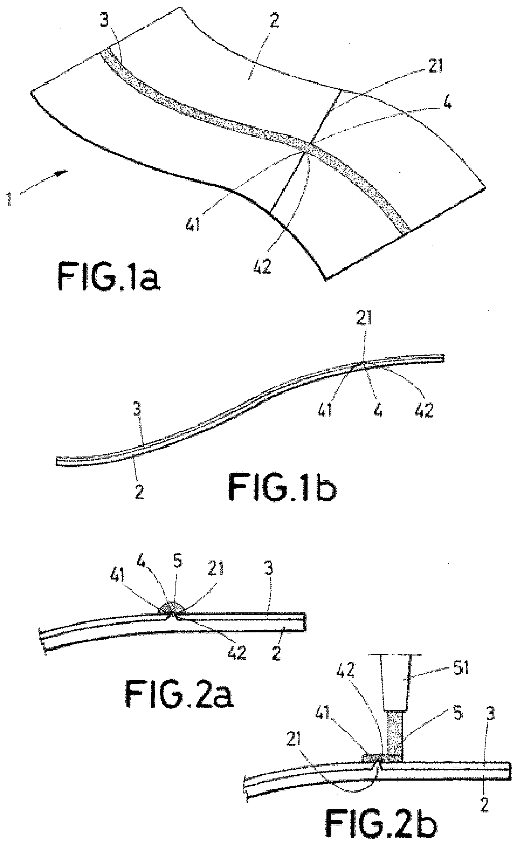

Figures 1a and 1b show an electronic assembly 1 comprising
a three-dimensional plastics substrate 2;
a conductive track 3 directly deposited on the three-dimensional plastics substrate 2, the conductive track 3 having a discontinuity that keeps electric current from passing from a first end 41 of the discontinuity to a second end 42 of the discontinuity 4.

This discontinuity 4 may be caused by some features of the plastics substrate 2, whatever they come from, for instance, slider lines, inserts borders, mechanization roughness from the mould or any kind of flatness disruption of plastic part surface once is already injected. In the embodiment shown in this figure 1, the three-dimensional plastics substrate 2 comprises a slider line 21 defining a slider line border, in such a way that the first end 41 of the discontinuity 4 and the second end 42 of the discontinuity 4 are contained in the slider line border. The slider line 21 acts as a barrier for electric conductivity because of its interaction with the conductive track 3, although this fact is not always visible. This issue is particularly relevant when the conductive track 3 has been deposited on the three-dimensional plastics substrate 2 by addressing a plasma flow which contains metal dust over the three-dimensional plastics substrate 2.

To solve this problem, the method of the invention proposes providing such an electronic assembly 1 and then providing a conductive material 5 in electric contact with both the first end 41 and the second end 42 of the discontinuity 4 of an electronic assembly 1 such as the one shown in figure 1.

Figure 2a shows the last step of this method when the conductive material 5 is placed in form of welding paste. This conductive material 5 is applied in electric contact with both the first end 41 and the second end 42 of the discontinuity 4 and then cured. The result of this step is a particular embodiment of an electronic assembly according to the invention, which comprises a conductive material 5 in electric contact with both the first end 41 and the second end 42 of the discontinuity 4.

Figure 2b shows the last step of this method when the conductive material 5 is placed by addressing a plasma flow which contains dust particles of the conductive material over the three-dimensional plastics substrate 2. This conductive material 5 is applied in electric contact with both the first end 41 and the second end 42 of the discontinuity 4 by means of a plasma nozzle 51 which deposits the conductive material 5 on the conductive track 3. The result of this step is a particular embodiment of an electronic assembly according to the invention, which comprises a conductive material 5 in electric contact with both the first end 41 and the second end 42 of the discontinuity 4.

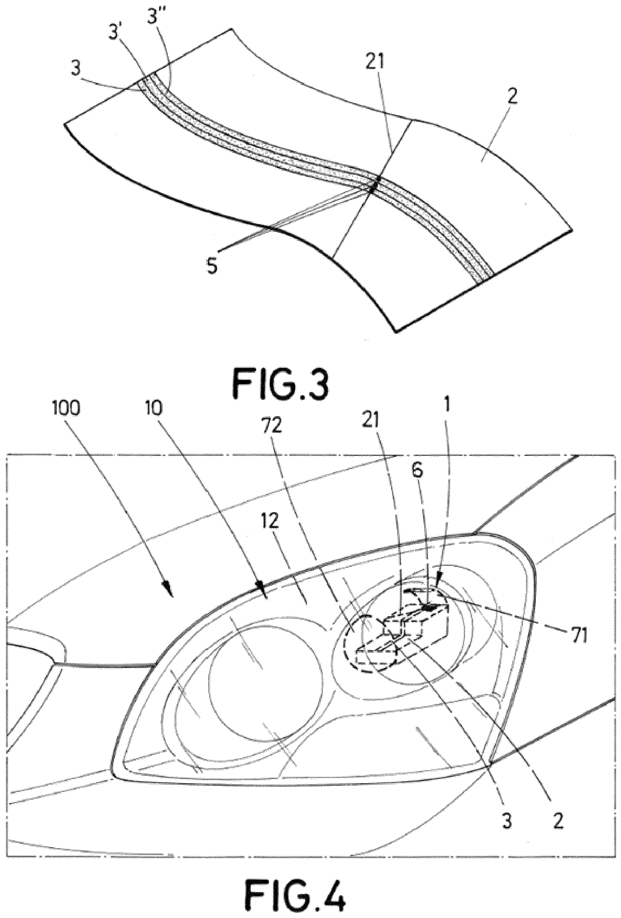

Figure 3 shows an example of electronic assembly 1 according to the invention, comprising three conductive tracks 3, 3', 3", the slider line 21 affecting to the three of them. In this case, three pieces of conductive material 5 are needed to restore the electric continuity. The three pieces of conductive material 5 may not be in contact, as it would produce a short-circuit between the conductive tracks 3, 3', 3".

Figure 4 shows a lighting device 10 comprising
an electronic assembly 1 according to the invention;
a semiconductor light source 6 in electric connection with the electronic assembly 1;
a reflector 71, and a projection lens 72, suitable for receiving light from the semiconductor light source 6 and projecting it in the shape of a light pattern in a forward direction; and
a housing 12 accommodating the electronic assembly 1, the semiconductor light source 6, the reflector 71 and the projection lens 72.

The forward direction should be understood as the advance direction of an automotive vehicle where the lighting device is intended to be installed.

In the particular embodiment shown in this figure, the optical elements include a reflector 71 and a projection lens 72. The reflector 71 is placed in the electronic assembly 1, arranged to reflect the light emitted by the semiconductor light source 6. The projection lens is in turn located in a forward position with respect to the lighting device 10, and receives the light from the light source 6 which has been reflected by the reflector 71. The projection lens 72 orientates this received light according to the vehicle advancing direction.

These optical elements 71, 72 makes the lighting device 10 suitable for being installed in an automotive vehicle 100 and able to perform lighting functions, such as high-beam and low-beam.

The electronic assembly 1 occupies a smaller volume than the electronic assemblies of the state of the art, and that makes that the lighting device may be smaller or house more elements without the need of increasing its size.

This lighting device 10 may be incorporated in an automotive vehicle, saving space and weight, because its manufacturing require less time and a lower number of elements.

## Claims

1. Method for providing electrical continuity in an electronic assembly (1), the method comprising the steps of
providing a plastics substrate (2);
directly depositing a conductive track (3) on the plastics substrate (2), the conductive track (3) having a discontinuity (4) that keeps electric current from passing from a first end (41) of the discontinuity (4) to a second end (42) of the discontinuity (4); and
providing a conductive material (5) in electric contact with both the first end (41) and the second end (42) of the discontinuity (4) thus achieving electrical continuity in the discontinuity (4), thereby obtaining an electronic assembly (1) with electrical continuity.

2. Method according to claim 1, wherein the step of directly depositing a conductive track (3) on the plastics substrate (2) is carried out by addressing a plasma flow which contains metal dust over the plastics substrate (2).

3. Method according to any of preceding claims, wherein the conductive material (5) is placed in form of welding paste.

4. Method according to any one of claims 1 or 2, wherein the conductive material (5) is placed by addressing a plasma flow which contains dust particles of the conductive material over the plastics substrate (2).

5. Method according to any of preceding claims, wherein the plastics substrate (2) is three-dimensional.

6. Electronic assembly (1) obtained by a method according to any one of the preceding claims.

7. Electronic assembly (1) comprising
a plastics substrate (2);
a conductive track (3) directly deposited on the plastics substrate (2), the conductive track (3) having a discontinuity that keeps electric current from passing from a first end (41) of the discontinuity to a second end (42) of the discontinuity (4); and
a conductive material (5) in electric contact with both the first end (41) and the second end (42) of the discontinuity (4).

8. Electronic assembly (1) according to claim 7, wherein the plastics substrate (2) comprises an irregularity (21) defining an irregularity border, in such a way that the first end (41) of the discontinuity (4) and the second end (42) of the discontinuity (4) are contained in the irregularity border.

9. Electronic assembly (1) according to any of claims 7 or 8, wherein the irregularity (21) is either a slider line, an inserts border or mechanization roughness from moulding.

10. Electronic assembly (1) according to any of claims 6 to 9, wherein the plastics substrate (2) is three-dimensional.

11. Lighting device (10) for automotive vehicle (100) comprising
an electronic assembly (1) according to any of claims 6 to 10;
a semiconductor light source (6) in electric connection with the electronic assembly (1);
an optical element (71, 72) suitable for receiving light emitted by the light source (6) and for shaping the light into a light pattern projected outside the lighting device (10); and
a housing (12) accommodating the electronic assembly (1), the semiconductor light source (6) and the optical element (71, 72).
